# EUROPEAN PATENT APPLICATION

(11) **EP 2 768 148 A2**
(43) Date of publication of application: **20.08.2014**
(21) Application number: 14155293.5
(22) Date of filing: 14.02.2014
(51) Int. Cl.: H04B 1/04

(54) **A Suppression Circuit for Suppressing Unwanted Transmitter Output**

(30) Priority: 19.02.2013 GB 201302897
(71) Applicant: ROKE MANOR RESEARCH LIMITED, Romsey, Hampshire SO51 0ZN (GB)
(72) Inventor: Hulbert, Anthony Peter, Southampton, SO16 3DF (GB)
(74) Representative: Wallin, Nicholas James

(57) **Abstract**

The invention relates to a frequency suppression circuit arrangement, which allows at least one selected frequency band to be suppressed by coupling the frequency suppression circuit between the input and output of an RF power amplifier. The frequency circuit in the embodiments of the invention down-converts a feedback signal derived from the amplified output signal into baseband signals. Each of the baseband signals is fed into an inverting amplifier to generate a negative baseband signal. The negative baseband signal is subsequently filtered to selectively pass the negative baseband signal. The filtered signal is subsequently up-converted into an RF signal. The up-converted RF signal is combined and provided to a coupler connected at the input of the power amplifier such that when the input signal is amplified by the RF power amplifier any signals at the selected frequency can be suppressed.

## Description

### Technical Field

The present invention relates to a suppression circuit; and in particular a suppression circuit for use with an amplifier in order to suppress signals, interference, or other distortion at one or more selected frequencies.

### Background of the Invention

The size of wireless communication devices is being driven by the marketplace towards smaller and smaller sizes due to consumers' demand for reduction in size and weight of such devices. In order to accommodate this trend, there is a drive to reduce the volume of the circuitry by, for example, placing components in close proximity. However, components such as radio receivers and radio transmitters operate on different, or sometimes multiple, frequency bands. Under these conditions there is always a concern that interference from inadvertent transmissions from the transmitter outside its intended transmission band but inside the intended reception band of the receiver may significantly degrade the sensitivity of the receiver. One mechanism that can generate such out of band signals from a transmitter is intermodulation between multiple carriers in the wanted signal band that generate signals outside the wanted signal band due to non-linearities in the transmitter's power amplifier Therefore, it would be beneficial to reduce the intermodulation products when the receivers and transmitters are placed in close proximity.

Two known examples of mitigating the intermodulation products are (1) to use a transmitter power amplifier with significantly higher linearity, for example, by specifying an amplifier capable of transmitting more power than is strictly necessary and backing off the input level or (2) to increase the separation between the transmit and receiver antennas. The former adds to expense and power consumption, and the latter is inconvenient and may be impractical.

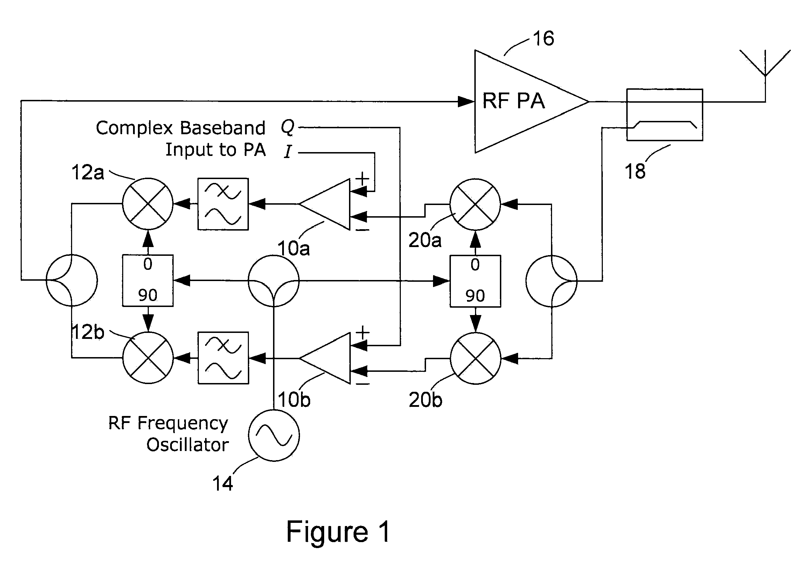

A number of methods are also known for linearising transmitter power amplifiers rather than using a power amplifier with high linearity and backing off the input power level. These include:
- *Digitad Pre-distortion* -distortion generated in the power amplifier is measured and the input is pre-distorted in inverse relationship to the power amplifier distortion in such a way that the cascade of the pre-distortion and the distortion generated in the power amplifier results in an output signal that is substantially without distortion.
- *Envelope Tracking -* Signals with high crest factors (i.e. peak to average power ratios) require substantial backing off of input power level so that the signal peaks are contained within the linear region of the power amplifier. However, this means that for a large proportion of the time the power amplifier is operating below its optimum operating point, resulting in poor efficiency. Envelope tracking power amplifiers improve efficiency by varying the power supply voltage to the amplifier in sympathy with the required signal envelope fluctuations. The variation in the power supply voltage is implemented using a switching regulator to avoid the reintroduction of inefficiency at this point.
- *LINC -* using this method, two constant envelope power amplifier outputs are summed to generate the required signal. The required output envelope characteristics are obtained by varying the mutual phases of the signals so that constructive and destructive interference create the necessary variations. However, it is noted that very few practical implementations exist because of the difficulty of achieving the modulation bandwidth needed to make the concept work.
- *Polar Loop -* This is a feedback linearization technique in which phase and amplitude of the signal are fed back independently to remove distortion in both components.
- *Cartesian Loop -* The principle of this method is analogous to conventional negative feedback as applied, for example, in high fidelity audio amplifiers. In that case the output of the amplifier is fed back to the input to generate an error signal. High gain within the feedback loop generates an input signal to the amplifier block that effectively pre-compensates for the distortion in that block. In the Cartesian loop the frequency of feedback is offset from the centre frequency of the signal to be transmitted to generate a complex baseband representation. An example of a conventional Cartesian loop is shown in Figure 1.

As shown in Figure 1, a composite amplifier 10a, 10b accepts a complex baseband, In-phase (I) and Quadrature-phase (Q), signal that is essentially up-converted in conventional fashion, by means of mixers 12a, 12b and a local oscillator 14, to provide an RF signal to a power amplifier 16. Connected to the output of the power amplifier 16 is an asymmetric coupler 18 which provides a feedback of the amplified signal. This signal is down-converted to complex baseband by means of mixers 20a, 20b and the local oscillator 14. The down-converted output signal is subtracted from the complex baseband signal to generate error signals which are amplified and passed through loop filters 22a, 22b to produce a pre-distorted signal that compensates for any distortions in the power amplifier 16.

Cartesian loop based power amplification is very effective in generating highly accurate, high power signals, provided the signal bandwidth is modest. For any given frequency offset from the centre frequency, the distortion is suppressed by a factor equal to the gain of the feedback loop at that frequency offset. Typically a Cartesian loop can yield excellent signal linearity for signal bandwidths up to about 25 kHz and useful improvements up to bandwidths of about 100 kHz. It is known that unity gain bandwidths of up to about 1 MHz are practical when allowance is made for the delays in the RF paths. However, it is noted that a conventional Cartesian loop is not practical for wideband signals.

### Summary of the Invention

Embodiments of the invention provide an unwanted signal suppression circuit arrangement, which allows at least one selected frequency band to be suppressed by coupling the suppression circuit between the input and output of an RF power amplifier. The frequency circuit in some embodiments of the invention down-converts a feedback signal derived from the amplified output signal into baseband signals, the down conversion using an oscillator running at a selected excision frequency that it is desired to remove from the circuit response. Each of the baseband signals is fed, if necessary, into an inverting amplifier to generate an inverted baseband signal. In other embodiments, where the power amplifier is itself inverting, then no inverting amplifier is required in the feedback loop, and the downconverted signal will be a negative baseband signal (with respect to the amplifier input). The inverted baseband signal is subsequently filtered to selectively pass the negative baseband signal. The filtered signal is subsequently up-converted into an RF signal. The up-converted RF signal is combined and provided to a coupler connected at the input of the power amplifier such that when the input signal is amplified by the RF power amplifier any signals at the selected excision frequency can be suppressed.

One aspect of the invention provides a suppression circuit for suppressing unwanted output from an amplifier having an input and an output, the input receiving an input signal, and the amplifier operable over a frequency band and operable to amplify the input signal to produce an amplified output signal, the suppression circuit connected between the input of the amplifier and the output of the amplifier, the suppression circuit comprising: a signal coupler coupled to the output of the amplifier, and arranged to provide a feedback signal derived from the amplified output signal; a signal processing circuit arranged to receive the feedback signal, and configured to process the feedback signal to generate a negative feedback signal at a selected frequency within the frequency band of the amplifier; and a further signal coupler coupled to the input of the amplifier, and arranged to receive the input signal and the negative feedback signal, and arranged to couple the negative feedback signal to the input signal, such that when the input signal is amplified by the amplifier any signals at the selected frequency can be suppressed. This arrangement allows any signals or interference that may appear in a frequency band to be suppressed while preserving the amplified signal. In the example of a transmitter as described above, this arrangement allows intermodulation products to be suppressed, and effectively allows the transmitter and the receiver to be placed in close proximity.

Preferably, the signal processing circuit comprises a down-converter operable to down-convert the feedback signal into baseband signals. One of the key advantages of performing signal processing in baseband is that the complexity of the processing components can be reduced significantly.

Preferably, the signal processing circuit further comprises a local oscillator operable to generate a local oscillator signal, wherein the down-converter comprises a first mixer and a second mixer configured to mix the feedback signal and the local oscillator signal into said baseband signals.

The baseband signals may comprise an in-phase component and a quadrature component.

The local oscillator signal is generated at an oscillator frequency substantially identical to that of the selected frequency. This is advantageous as it provides the flexibility of adapting the circuit to operate at different frequencies simply by changing the operating frequency of the local oscillator.

Preferably, the signal processing circuit further comprises a first inverting amplifier and a second inverting amplifier coupled respectively to an output of said first mixer and said second mixer, the inverting amplifiers being operable to invert the baseband signals to produce negative baseband signals.

The signal processing circuit may further comprise a first filter and a second filter coupled to the first inverting amplifier and the second amplifier respectively, wherein the filters are operable to selectively pass the negative baseband signals.

The filtered negative baseband signals may be up-converted and combined by means of a signal combiner to produce said negative feedback signal.

In one embodiment, the invention provides a multi-frequency suppression circuit comprising a plurality of signal processing circuits of the above aspect, the feedback signal being divided between the plurality of circuits by means of a signal splitter, and the negative feedback signals from the plurality of circuits being combined by means of a signal combiner. Preferably, the plural signal processing circuits receive different excision frequencies from their local oscillators, to allow for multiple excision frequencies to be suppressed.

A further aspect of the invention provides a multi-frequency suppression circuit for suppressing unwanted outputs at multiple frequencies from an amplifier having an input and an output, the input receiving an input signal, and the amplifier operable over a frequency band and operable to amplify the input signal to produce an amplified output signal, the multi-frequency suppression circuit connected between the input of the amplifier and the output of the amplifier, the multi-frequency suppression circuit comprising a signal coupler coupled to the output of the amplifier, and arranged to provide a feedback signal derived from the amplified output signal, a signal splitter configured to split the feedback signal into a plurality of feedback signals, a plurality of signal processing circuits, the circuits being arranged to receive the plurality of feedback signals, and configured to process the plurality of feedback signals to generate respective negative feedback signals at selected frequencies within the frequency band of the amplifier, a signal combiner configured to combine said generated negative feedback signals from said signal processing circuits to produce a combined negative feedback signal, and a further signal coupler coupled to the input of the amplifier, and arranged to receive the input signal and the combined negative feedback signal, and arranged to couple the combined negative feedback signal to the input signal, such that when the input signal is amplified by the amplifier any signal at the selected frequencies can be suppressed.

Preferably, the plurality of signal processing circuits comprise respective down-converters operable to down-convert the feedback signal into baseband signals.

Preferably, the plurality of signal processing circuits further comprise local oscillators operable to generate respective local oscillator signals, wherein the down-converters respectively comprise a first mixer and a second mixer configured to mix the feedback signal and the respective local oscillator signal into said baseband signals.

The respective local oscillators of the plurality of sets of signal processing circuit may be set to different frequencies.

Preferably, the local oscillator signals are generated at an oscillator frequency substantially identical to that of the respective selected frequency.

In one embodiment the respective local oscillators comprise a master oscillator, and one or more difference oscillators arranged to receive the master oscillator signal and to generate different frequency signals synchronously therewith. Alternatively, where the multiple frequencies are further apart the respective local oscillators are temporarily tuned together. Both cases allow cross calibration to be performed between the multiple loops. In one embodiment the cross-calibration is performed by leakage detection means arranged to synchronously detect any leakage signal corresponding to a difference in frequencies of the respective local oscillators.

From another aspect another embodiment of the invention provides a method of suppressing unwanted transmitter output in a radio frequency (RF) amplifier, comprising: obtaining a feedback signal from the output of the RF amplifier; downconverting an excision frequency band of the feedback signal to one or more feedback signal baseband components, the excision frequency band being a band that it is desired to remove from the output of the RF amplifier; low pass filtering the feedback signal baseband components to remove signals outside the excision frequency band; upconverting the filtered feedback signal baseband components to RF; and feeding back the upconverted feedback signal to the input of the RF amplifier; the method further comprising inverting the feedback signal at any point in the signal processing chain to provide a negative feedback signal to the input of the RF amplifier.

In a preferred embodiment the inverting is performed at baseband by one or more inverting amplifiers.

In one embodiment the downconverting comprises: receiving a local oscillator signal at a frequency corresponding to the excision frequency; and mixing the local oscillator signal with the feedback signal to produce the one or more baseband components.

In one embodiment the upconverting comprises: receiving a local oscillator signal at a frequency corresponding to the excision frequency; and mixing the local oscillator signal with the one or more filtered feedback signal baseband baseband components to produce an upconverted RF signal to be amplified.

In preferred embodiments the excision frequency band is downconverted to in-phase (I) and quadrature (Q) baseband components. I and Q signals are significantly easier to process than non-complex signals.

One embodiment of the invention further comprises: downconverting one or more further excision frequency bands of the feedback signal to one or more further feedback signal baseband components, the one or more excision frequency bands being bands that it is desired to remove from the output of the RF amplifier; low pass filtering the further feedback signal baseband components to remove signals outside the excision frequency bands; upconverting the further filtered feedback signal baseband components to RF; and feeding back the further upconverted feedback signals to the input of the RF amplifier; the method further comprising inverting the further feedback signals at any point in the signal processing chain to provide negative feedback signals to the input of the RF amplifier; wherein a plurality of excision frequency bands may be removed from the RF signal to be transmitted.

In one embodiment downconverting and upconverting is performed using respective local oscillators set to the excision frequencies, wherein the respective local oscillators comprise a master oscillator, and one or more difference oscillators arranged to receive the master oscillator signal and to generate different frequency signals synchronously therewith.

From another aspect another embodiment of the invention also provides a method of receiving RF signals using a RF receiver collocated with a RF transmitter performing suppression according to any of the above aspects, the RF receiver being a zero intermediate frequency (IF) receiver, the method further comprising using for downconversion either the same local oscillator as is used to generate at least one of the suppressed frequencies in the suppression circuit, or a local oscillator that is phase-locked to said same local oscillator.

### Description of the Drawings

Further features and advantages of the present invention will become apparent from the following description of embodiments thereof, presented by way of example only, and by reference to the accompanying drawings, wherein like reference numerals refer to like parts, and wherein: -
Figure 1 is a circuit diagram of a conventional Cartesian loop arrangement;
Figure 2 illustrates a circuit diagram of a frequency suppression circuit of an embodiment of the invention;
Figure 3 illustrates a circuit diagram of a frequency suppression circuit of a further embodiment of the invention; and
Figure 4 is a diagram illustrating an example frequency response of the embodiment.

### Description of the Embodiments

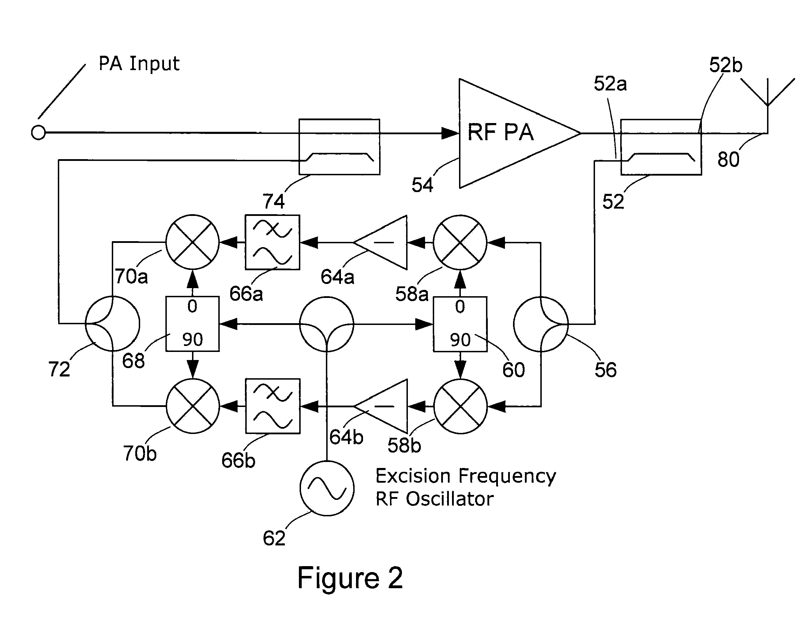

A first embodiment of the present invention is shown in Figure 2. As illustrated in Figure 2, an RF input signal is provided to an input of an RF power amplifier 54 that is known to a person skilled in art. The RF power amplifier 54 may be, for example, a class A, B, AB, or C amplifier operable to amplify the RF input signal to provide an amplified output signal.

A suppression circuit is provided, comprising a first coupler 52 coupled to an output of the RF power amplifier 54. The coupler 52 may be, for example, a low loss asymmetric coupler configured such that a portion of the amplified output signal is fed back to the suppression circuit through a first output 52a of the coupler 52. A second output 52b of the coupler 52 is coupled to an antenna 80 to allow the amplified signal to be transmitted.

The first output 52a of the coupler 52 is coupled to an RF splitter 56 arranged to split the feedback signal into the In-phase (I) and Quadrature-phase (Q) paths which are down-converted to complex baseband signals by means of mixers 58a, 58b, 90° phase shifter 60 and a local oscillator 62.

As shown in Figure 2, the local oscillator 62 is coupled to frequency mixers 58a, 58b via phase shifter 60. The frequency of the local oscillator is configured to operate at a centre frequency of the band in which the suppression circuit 50 is desired to suppress.

In the I-branch, the down-converted signal is passed to an inverting amplifier 64a to generate a negative feedback signal in baseband. Similarly, in the Q-branch, the down-converted signal is passed to an inverting amplifier 64b to generate a negative baseband feedback signal.

The signals in each of the I and Q paths are provided to low-pass filters 66a, 66b which selectively pass signals of the band of which the suppression circuit 50 is configured to suppress.

The filtered signals are up-converted by means of mixers 70a, 70b, phase shifter 68 and the local oscillator 62. The up-converted signals are combined by an RF combiner 72, and subsequently the combined signal is provided to a second coupler 74 connected to the input of the RF power amplifier 54.

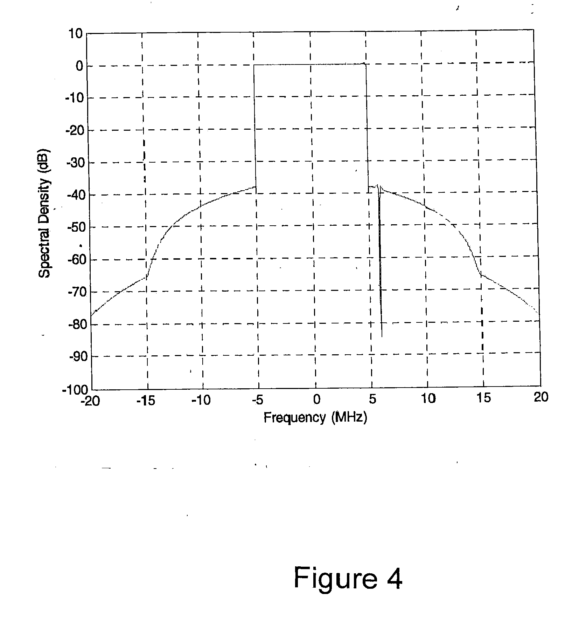

With the above arrangement, the suppression circuit of embodiments of the invention allows an input signal to the RF power amplifier 54 to suppress signals at an unwanted frequency band of the amplified output signal. Effectively, this allows an interference from a transmit band to be removed. As shown in the frequency response plot in Figure 4, the frequency suppression circuit, in this example, creates a deep null in the transmission spectrum at +6MHz. In this example, the depth of the null is 84.5 dB, which is a suppression of 45.5 dB relative to the unsuppressed spectrum at +6MHz.

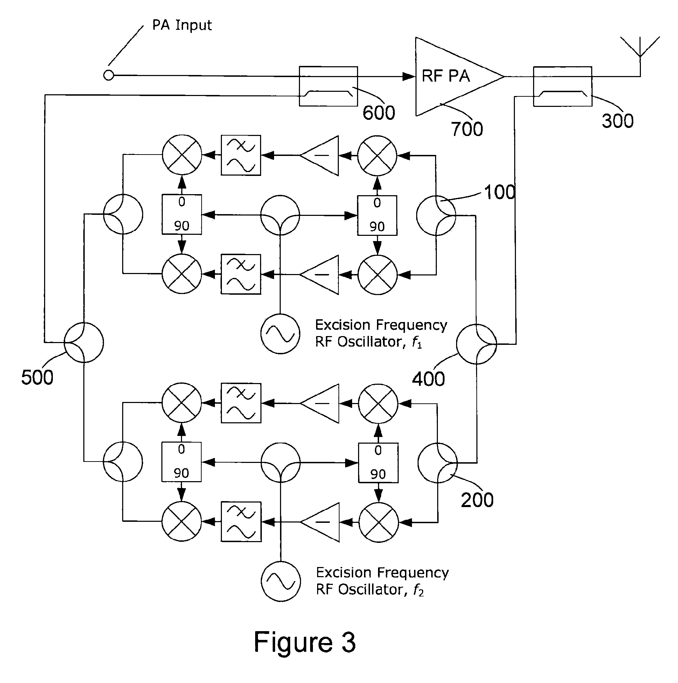

A second embodiment of the invention will now be described with respect to Figure 3. As illustrated in Figure 3, two or more of the suppression circuits described previously with respect to Figure 2 are provided. As shown in Figure 3, an RF splitter 400 is provided before each suppression circuit 100, 200 to split the feedback signal from the first coupler 300 into two paths, each path is connected to a respective frequency suppression circuit 100, 200. Each of the suppression circuits may be configured to operate at different frequencies so that multiple interfering frequencies in a transmit band can be suppressed. In the illustrated embodiment in Figure 3, the arrangement is capable of suppressing interference at two separate frequencies, f1 and f2, being the frequencies of operation of the excision oscillators. The output of the suppression circuits 100, 200 are combined using an RF combiner 500 and the combined output is provided to a second coupler 600 at the input of the RF power amplifier. The components and the operation of the suppression circuits 100, 200 are similar to those described with respect to the suppression circuit 50 of Figure 2, and therefore details of the interference suppression circuits 100, 200 in Figure 3 will not be described.

In conclusion, embodiments of the invention provide a suppression circuit arrangement, which allows at least one selected frequency band to be suppressed by coupling the suppression circuit of the invention between an input and an output of an RF power amplifier. Effectively, the suppression circuit in the embodiments of the invention down-converts a portion of the amplified output signal into baseband before feeding into an inverting amplifier to generate a negative feedback signal. The negative feedback signal is subsequently filtered and up-converted into an RF signal. The up-converted RF signal is provided to a coupler connected at the input of the power amplifier so that when the input signal is amplified by the amplifier any signals at the selected frequency can be suppressed.

It is noted that effective suppression of interference at the loop oscillator frequency relies on perfect balance of the mixers that are fed from the feedback signal from the output of the power amplifier. In the arrangements of Figures 2 and 3, the mixer imbalance from the components may produce significant power levels at the oscillator frequency(ies). This can be overcome by using any one of the following methods:
- *Cross cadibrate -* In the multiple circuit arrangement of Figure 3 the leakage signals from the two loops will appear as offset signals. For example, suppose the two oscillators' frequencies have a difference between *f*₁ and *f*₂ of 100 kHz. In that case both oscillators will see the other's leakage signal *at* 100 kHz. It is noted that by synchronously detecting the leakage signal its power can be measured. If one of the two oscillators is generated from the other by a difference oscillator then that difference oscillator can be used for the synchronous down conversion. If the required frequencies for normal operation are further apart, the oscillators can temporarily be tuned together for the purpose of calibration.
- *Use zero-IF collocated receiver -* If the collocated receiver uses zero IF (Intermediate Frequency) with either the same actual oscillator that was used for the interference cancellation circuit or another oscillator that is phase locked to the first oscillator then the leakage will be removed by the AC coupling that is commonly used in the baseband circuitry of such receivers.

Thus, although oscillator leakage through mixer DC offsets is a problem, it can be mitigated or solved through the use of either or both of the above techniques. Although more complex than the latter, the former solution has the advantage that the leakage signal does not radiate in such a way as to be seen "outside" the system boundaries. Furthermore, it removes the need for a coherent link between the transmitter and the receiver.

Within the embodiment above, the negative feedback of the excision frequency is obtained by way of the inverting amplifiers located in the I and Q branches of the feedback loop. In other embodiments, however, the signal inversion may be obtained in a different way. For example, the RF amplifier itself may be an inverting amplifier, in which case no further inversion is needed in the feedback loop. Alternatively, inversion may be performed at some other part of the feedback loop signal processing chain. The important element is that there is negative feedback of the excision frequency to be suppressed, in order to provide a notch in the frequency response of the RF amplifier at the desired frequency or frequencies.

In another embodiment the inverters and filters may advantageously be combined into an inverting filter. For example, an inverting integrator based on an operational amplifier as is well known in the art may be used.

Various further modifications may be made, either by addition, deletion, or substitution, to the above described embodiments to provide further embodiments, any and all of which are intended to be encompassed by the appended claims.

There follows a list of numbered features defining some embodiments of the present invention. Where a numbered feature refers to one or more earlier numbered feature then those features may be considered in combination.
1. A suppression circuit for suppressing unwanted output from an amplifier having an input and an output, the input receiving an input signal, and the amplifier operable over a frequency band and operable to amplify the input signal to produce an amplified output signal, the suppression circuit connected between the input of the amplifier and the output of the amplifier, the suppression circuit comprising:
   a signal coupler coupled to the output of the amplifier, and arranged to provide a feedback signal derived from the amplified output signal;
   a signal processing circuit arranged to receive the feedback signal, and configured to process the feedback signal to generate a negative feedback signal at a selected frequency within the frequency band of the amplifier; and
   a further signal coupler coupled to the input of the amplifier, and arranged to receive the input signal and the negative feedback signal, and arranged to couple the negative feedback signal to the input signal, such that when the input signal is amplified by the amplifier any signals at the selected frequency can be suppressed.
2. A suppression circuit according to feature 1, wherein the signal processing circuit comprises a down-converter operable to down-convert the feedback signal into baseband signals.
3. A suppression circuit according to feature 2, wherein the signal processing circuit further comprises a local oscillator operable to generate a local oscillator signal, wherein the down-converter comprises a first mixer and a second mixer configured to mix the feedback signal and the local oscillator signal into said baseband signals.
4. A suppression circuit according to feature 3 wherein the baseband signals comprise an in-phase component and a quadrature component.
5. A suppression circuit according to feature 3 or feature 4, wherein the local oscillator signal is generated at an oscillator frequency substantially identical to that of the selected frequency.
6. A suppression circuit according to any one of features 3 to 5, wherein the signal processing circuit further comprises a first inverting amplifier and a second inverting amplifier coupled respectively to an output of said first mixer and said second mixer, the inverting amplifiers being operable to invert the baseband signals to produce negative baseband signals.
7. A suppression circuit according to any of the preceding features, wherein the signal processing circuit further comprises one or more filters operable to selectively pass the negative baseband feedback signal.
8. A suppression circuit according to feature 7, wherein the filtered negative baseband signals are up-converted and combined by means of a signal combiner to produce said negative feedback signal.
9. A multi-frequency suppression circuit comprising a plurality of signal processing circuits of any of the preceding features, the feedback signal being divided between the plurality circuits by means of a signal splitter, and the negative feedback signals from the plurality of circuits being combined by means of a signal combiner.
10. A multi-frequency suppression circuit for suppressing unwanted outputs at multiple frequencies from an amplifier having an input and an output, the input receiving an input signal, and the amplifier operable over a frequency band and operable to amplify the input signal to produce an amplified output signal, the multi-frequency suppression circuit connected between the input of the amplifier and the output of the amplifier, the multi-frequency suppression circuit comprising:
   a signal coupler coupled to the output of the amplifier, and arranged to provide a feedback signal derived from the amplified output signal;
   a signal splitter configured to split the feedback signal into a plurality of feedback signals;
   a plurality of sets of signal processing circuit, the sets respectively arranged to receive one of said plurality of feedback signals, and configured to process said one of said plurality of feedback signals to generate a respective negative feedback signal at a selected frequency within the frequency band of the amplifier;
   a signal combiner configured to combine said generated negative feedback signals from said signal processing circuits to produce a combined negative feedback signal; and
   a further signal coupler coupled to the input of the amplifier, and arranged to receive the input signal and the combined negative feedback signal, and arranged to couple the combined negative feedback signal to the input signal, such that when the input signal is amplified by the amplifier any signal at the selected frequencies can be suppressed.
11. The multi-frequency circuit of feature 10, wherein said plurality of signal processing circuits respectively comprise down-converters operable to down-convert the feedback signal into baseband signals.
12. A multi-frequency suppression circuit according to feature 11, wherein said plurality of signal processing circuits further comprise respective local oscillators operable to generate local oscillator signals, wherein the down-converters respectively comprise a first mixer and a second mixer configured to mix the feedback signal and the respective local oscillator signal into said baseband signals.
13. A multi-frequency suppression circuit according to feature 11 or feature 12, wherein the respective local oscillators of the plurality of sets of signal processing circuits are set to different frequencies.
14. A multi-frequency suppression circuit according to feature 12 or feature 13, wherein the respective local oscillator signals are generated at oscillator frequencies substantially identical to that of the respective selected frequencies to be suppressed.
15. A multi-frequency suppression circuit according to any of features 12 to 14, wherein the respective local oscillators comprise a master oscillator, and one or more difference oscillators arranged to receive the master oscillator signal and to generate different frequency signals synchronously therewith.
16. A multi-frequency suppression circuit according to any of features 12 to 14, wherein the respective local oscillators are temporarily tuned together to permit calibration.
17. A multi-frequency suppression circuit according to any of features 15 or 16, and further comprising leakage detection means arranged to synchronously detect any leakage signal corresponding to a difference in frequencies of the respective local oscillators.
18. An RF receiver collocated with an RF transmitter having a suppression circuit according to any of the preceding features, the RF receiver being a zero intermediate frequency (IF) receiver, and being arranged to use either the same local oscillator as is used to generate at least one of the suppressed frequencies in the suppression circuit, or a local oscillator that is phase-locked to said same local oscillator.
19. A method of suppressing unwanted transmitter output in a radio frequency (RF) amplifier, comprising:
   obtaining a feedback signal from the output of the RF amplifier;
   downconverting an excision frequency band of the feedback signal to one or more feedback signal baseband components, the excision frequency band being a band that it is desired to remove from the output of the RF amplifier;
   low pass filtering the feedback signal baseband components to remove signals outside the excision frequency band;
   upconverting the filtered feedback signal baseband components to RF; and feeding back the upconverted feedback signal to the input of the RF amplifier;
   the method further comprising inverting the feedback signal at any point in the signal processing chain to provide a negative feedback signal to the input of the RF amplifier.
20. A method according to feature 19, wherein the downconverting comprises:
   receiving a local oscillator signal at a frequency corresponding to the excision frequency; and
   mixing the local oscillator signal with the feedback signal to produce the one or more baseband components.
21. A method according to any of features 19 or 20, wherein the upconverting comprises:
   receiving a local oscillator signal at a frequency corresponding to the excision frequency; and
   mixing the local oscillator signal with the one or more filtered feedback signal baseband baseband components to produce an upconverted RF signal to be amplified.
22. A method according to any of features 19 to 21, wherein the excision frequency band is downconverted to in-phase (I) and quadrature (Q) baseband components.
23. A method according to any of features 19 to 22, and further comprising:
   downconverting one or more further excision frequency bands of the feedback signal to one or more further feedback signal baseband components, the one or more excision frequency bands being bands that it is desired to remove from the output of the RF amplifier;
   low pass filtering the further feedback signal baseband components to remove signals outside the excision frequency bands;
   upconverting the further filtered feedback signal baseband components to RF; and
   feeding back the further upconverted feedback signals to the input of the RF amplifier;
   the method further comprising inverting the further feedback signals at any point in the signal processing chain to provide negative feedback signals to the input of the RF amplifier;
   wherein a plurality of excision frequency bands may be removed from the RF signal to be transmitted.
24. A method according to feature 23, wherein downconverting and upconverting is performed using respective local oscillators set to the excision frequencies.
25. A method according to feature 24, wherein the respective local oscillators comprise a master oscillator, and one or more difference oscillators arranged to receive the master oscillator signal and to generate different frequency signals synchronously therewith.
26. A method according to feature 24, wherein the respective local oscillators are temporarily tuned together to permit calibration.
27. A method according to any of features 24 to 26, and further comprising synchronously detecting any leakage signal corresponding to a difference in frequencies of the respective local oscillators.
28. A method according to any of features 19 to 27, wherein the feedback signals are inverted at baseband.
29. A method of receiving RF signals using a RF receiver collocated with a RF transmitter performing suppression according to any of features 19 to 28, the RF receiver being a zero intermediate frequency (IF) receiver, the method further comprising using for downconversion either the same local oscillator as is used to generate at least one of the suppressed frequencies in the suppression circuit, or a local oscillator that is phase-locked to said same local oscillator.

## Claims

1. A suppression circuit for suppressing unwanted output from an amplifier having an input and an output, the input receiving an input signal, and the amplifier operable over a frequency band and operable to amplify the input signal to produce an amplified output signal, the suppression circuit connected between the input of the amplifier and the output of the amplifier, the suppression circuit comprising:
a signal coupler coupled to the output of the amplifier, and arranged to provide a feedback signal derived from the amplified output signal;
a signal processing circuit arranged to receive the feedback signal, and configured to process the feedback signal to generate a negative feedback signal at a selected frequency within the frequency band of the amplifier; and
a further signal coupler coupled to the input of the amplifier, and arranged to receive the input signal and the negative feedback signal, and arranged to couple the negative feedback signal to the input signal, such that when the input signal is amplified by the amplifier any signals at the selected frequency can be suppressed.

2. A suppression circuit according to claim 1, wherein the signal processing circuit comprises a down-converter operable to down-convert the feedback signal into baseband signals.

3. A suppression circuit according to claim 2, wherein the signal processing circuit further comprises a local oscillator operable to generate a local oscillator signal, wherein the down-converter comprises a first mixer and a second mixer configured to mix the feedback signal and the local oscillator signal into said baseband signals;
wherein optionally the baseband signals comprise an in-phase component and a quadrature component;
wherein optionally the local oscillator signal is generated at an oscillator frequency substantially identical to that of the selected frequency; and
wherein optionally the signal processing circuit further comprises a first inverting amplifier and a second inverting amplifier coupled respectively to an output of said first mixer and said second mixer, the inverting amplifiers being operable to invert the baseband signals to produce negative baseband signals.

4. A suppression circuit according to any of the preceding claims, wherein the signal processing circuit further comprises one or more filters operable to selectively pass the negative baseband feedback signal;
wherein optionally the filtered negative baseband signals are up-converted and combined by means of a signal combiner to produce said negative feedback signal.

5. A multi-frequency suppression circuit for suppressing unwanted outputs at multiple frequencies from an amplifier having an input and an output, the input receiving an input signal, and the amplifier operable over a frequency band and operable to amplify the input signal to produce an amplified output signal, the multi-frequency suppression circuit connected between the input of the amplifier and the output of the amplifier, the multi-frequency suppression circuit comprising:
a signal coupler coupled to the output of the amplifier, and arranged to provide a feedback signal derived from the amplified output signal;
a signal splitter configured to split the feedback signal into a plurality of feedback signals;
a plurality of sets of signal processing circuit, the sets respectively arranged to receive one of said plurality of feedback signals, and configured to process said one of said plurality of feedback signals to generate a respective negative feedback signal at a selected frequency within the frequency band of the amplifier;
a signal combiner configured to combine said generated negative feedback signals from said signal processing circuits to produce a combined negative feedback signal; and
a further signal coupler coupled to the input of the amplifier, and arranged to receive the input signal and the combined negative feedback signal, and arranged to couple the combined negative feedback signal to the input signal, such that when the input signal is amplified by the amplifier any signal at the selected frequencies can be suppressed.

6. The multi-frequency circuit of claim 5, wherein said plurality of signal processing circuits respectively comprise down-converters operable to down-convert the feedback signal into baseband signals;
wherein optionally said plurality of signal processing circuits further comprise respective local oscillators operable to generate local oscillator signals, wherein the down-converters respectively comprise a first mixer and a second mixer configured to mix the feedback signal and the respective local oscillator signal into said baseband signals;
wherein optionally the respective local oscillators of the plurality of sets of signal processing circuits are set to different frequencies.

7. A multi-frequency suppression circuit according to claim 6, wherein the respective local oscillator signals are generated at oscillator frequencies substantially identical to that of the respective selected frequencies to be suppressed.

8. A multi-frequency suppression circuit according to any of claims 6 or 7, wherein the respective local oscillators comprise a master oscillator, and one or more difference oscillators arranged to receive the master oscillator signal and to generate different frequency signals synchronously therewith.

9. A multi-frequency suppression circuit according to any of claims 6 or 7, wherein the respective local oscillators are temporarily tuned together to permit calibration.

10. A multi-frequency suppression circuit according to any of claims 8 or 9, and further comprising leakage detection means arranged to synchronously detect any leakage signal corresponding to a difference in frequencies of the respective local oscillators.

11. An RF receiver collocated with an RF transmitter having a suppression circuit according to any of the preceding claims, the RF receiver being a zero intermediate frequency (IF) receiver, and being arranged to use either the same local oscillator as is used to generate at least one of the suppressed frequencies in the suppression circuit, or a local oscillator that is phase-locked to said same local oscillator.

12. A method of suppressing unwanted transmitter output in a radio frequency (RF) amplifier, comprising:
obtaining a feedback signal from the output of the RF amplifier;
downconverting an excision frequency band of the feedback signal to one or more feedback signal baseband components, the excision frequency band being a band that it is desired to remove from the output of the RF amplifier;
low pass filtering the feedback signal baseband components to remove signals outside the excision frequency band;
upconverting the filtered feedback signal baseband components to RF; and
feeding back the upconverted feedback signal to the input of the RF amplifier;
the method further comprising inverting the feedback signal at any point in the signal processing chain to provide a negative feedback signal to the input of the RF amplifier.

13. A method according to claim 12, wherein the downconverting comprises:
receiving a local oscillator signal at a frequency corresponding to the excision frequency; and
mixing the local oscillator signal with the feedback signal to produce the one or more baseband components;
wherein the upconverting comprises:
receiving a local oscillator signal at a frequency corresponding to the excision frequency; and
mixing the local oscillator signal with the one or more filtered feedback signal baseband baseband components to produce an upconverted RF signal to be amplified;
wherein optionally the excision frequency band is downconverted to in-phase (I) and quadrature (Q) baseband components.

14. A method according to any of claims 12 to 13, and further comprising:
downconverting one or more further excision frequency bands of the feedback signal to one or more further feedback signal baseband components, the one or more excision frequency bands being bands that it is desired to remove from the output of the RF amplifier;
low pass filtering the further feedback signal baseband components to remove signals outside the excision frequency bands;
upconverting the further filtered feedback signal baseband components to RF; and
feeding back the further upconverted feedback signals to the input of the RF amplifier;
the method further comprising inverting the further feedback signals at any point in the signal processing chain to provide negative feedback signals to the input of the RF amplifier;
wherein a plurality of excision frequency bands may be removed from the RF signal to be transmitted.

15. A method according to claim 14, wherein downconverting and upconverting is performed using respective local oscillators set to the excision frequencies;
wherein optionally:
i) the respective local oscillators comprise a master oscillator, and one or more difference oscillators arranged to receive the master oscillator signal and to generate different frequency signals synchronously therewith; or
ii) the respective local oscillators are temporarily tuned together to permit calibration.
